# EUROPEAN PATENT APPLICATION

(11) **EP 4 462 465 A1**
(43) Date of publication of application: **13.11.2024**
(21) Application number: 22918777.8
(22) Date of filing: 12.12.2022
(51) Int. Cl.: H01L 21/20

(54) **NITRIDE SEMICONDUCTOR SUBSTRATE AND METHOD FOR PRODUCING SAME**

(30) Priority: 05.01.2022 JP 2022000653
(71) Applicant: Shin-Etsu Handotai Co., Ltd., Tokyo 100-0004 (JP)
(72) Inventor: TSUCHIYA, Keitaro, Annaka-shi, Gunma 379-0196 (JP); QU, Weifeng, Annaka-shi, Gunma 379-0196 (JP)
(74) Representative: Mooser, Sebastian Thomas
(86) International application number: PCT/JP2022/045748
(87) International publication number: WO 2023/132191

(57) **Abstract**

The present invention provides a nitride semiconductor substrate, including: a silicon single crystal substrate having a front surface and a back surface; and a nitride semiconductor thin film formed on the front surface, in which the silicon single crystal substrate has a carbon diffusion layer that has been implanted with carbon and has a carbon concentration higher than a bulk portion of the silicon single crystal substrate in at least the front surface and the back surface, and the carbon concentration in the carbon diffusion layer is 5E+16 atoms/cm³ or more. This provides a nitride semiconductor substrate that can suppress warp failure caused by plastic deformation during epitaxial growth and device processes when the nitride semiconductor substrate is produced using a silicon single crystal substrate, and a method for producing the nitride semiconductor substrate.

## Description

### TECHNICAL FIELD

The present invention relates to a nitride semiconductor substrate and a method for producing the same.

### BACKGROUND ART

High-frequency devices are being developed to integrate devices such as antennas, amplifiers, switches, and filters in order to reduce the size and cost. Further, as the frequency becomes higher, the circuit becomes more complicated, and various device materials such as silicon CMOS, devices using group III-V semiconductors and nitride semiconductors, and filters using piezoelectric materials are used.

As a substrate used as the base of these devices, it is considered that a silicon single crystal substrate, which is inexpensive and has a large diameter wafer on the market, is suitable. In particular, as the substrate for the high frequency devices, a silicon single crystal substrate with low oxygen, which has a high resistivity and shows little change in the resistivity due to thermal donor, is considered suitable.

However, the silicon single crystal substrate having a high resistivity and low oxygen has poor mechanical properties as compared with a low resistivity CZ substrate and has a problem that plastic deformation is likely to occur due to propagation of dislocations. In particular, in the growth of GaN on the silicon single crystal substrate, the stress due to the difference in lattice constant and the difference in thermal expansion coefficient tends to cause an increase of warps and plastic deformation; thus, stress reduction is performed by growth conditions and a relaxation layer.

For example, in Patent Document 1, stress relaxation is performed by using an intermediate layer of gallium nitride based compound semiconductors that are periodically laminated a plurality of times, and a wafer having small warps and cracks is produced. However, it is concerned that the production of a complex intermediate layer may increase the growth time and reduce the degree of freedom in design.

In addition, although Patent Document 2 discloses a technique for obtaining high-strength silicon single crystal wafers by performing RTA after carbon doping in the bulk crystal stage, it is difficult to obtain a crystal having controlled carbon concentration, and a decrease in yield is concerned.

Moreover, Patent Document 3 includes a step to remove the surface layer after carbon doping by RTA. Because of the step to remove the surface layer, defects and contamination caused by etching residues are concerned, and thus, a method to grow a GaN epitaxial layer in a mirror shape without removing the surface layer is desired.

### CITATION LIST

### PATENT LITERATURE

Patent Document 1: JP 2012-79952 A
Patent Document 2: WO 2004/008521 A1
Patent Document 3: JP 2021-008386 A

### SUMMARY OF INVENTION

### TECHNICAL PROBLEM

In high-frequency devices, in order to improve high-frequency characteristics, it is necessary to reduce parasitic capacitance of the devices and support substrates and peripheral packages. It is considered that use of a high resistance silicon single crystal substrate that does not generate a thermal donor for a support substrate or a package to reduce the parasitic capacity can improve the characteristics and have an advantage in terms of cost.

On the other hand, the device includes steps such as epitaxial growth on the substrate, heat treatment, and bonding, but stress is generated to the substrate during the steps due to the differences in lattice constant and thermal expansion coefficient between different materials. However, a substrate having a high resistance and low oxygen has a demerit of being more prone to plastic deformation compared with a conventional low resistance substrate, when dislocated. When the plastic deformation occurs, the wafer is greatly distorted and cannot return to the original shape thereof, which has a risk of warp abnormality or bonding failure.

The present invention has been made in view of the above-described problem. An object of the present invention is to provide a nitride semiconductor substrate that can suppress warp failure caused by plastic deformation during epitaxial growth and device processes when the nitride semiconductor substrate is produced using a silicon single crystal substrate, and a method for producing the nitride semiconductor substrate.

### SOLUTION TO PROBLEM

To achieve the object above, the present invention provides a nitride semiconductor substrate comprising:
a silicon single crystal substrate having a front surface and a back surface; and a nitride semiconductor thin film formed on the front surface, wherein
the silicon single crystal substrate has a carbon diffusion layer that has been implanted with carbon and has a carbon concentration higher than a bulk portion of the silicon single crystal substrate in at least the front surface and the back surface, and
the carbon concentration in the carbon diffusion layer is 5E+16 atoms/cm³ or more.

Such a nitride semiconductor substrate can suppress warp failure caused by plastic deformation during epitaxial growth or a device process, when the nitride semiconductor substrate is produced using the silicon single crystal substrate.

In addition, it is preferred that the silicon single crystal substrate has a resistivity of 100 Qcm or more and an oxygen concentration of 7E+17 atoms/cm³ or less.

In the present invention, even when the silicon single crystal substrate having a high resistivity, a low oxygen concentration, and low mechanical strength is used, it is possible to make a nitride semiconductor wafer in which plastic deformation and a warp are suppressed.

Moreover, the carbon diffusion layer preferably has a thickness of 1 um or more.

According to the nitride semiconductor substrate, the carbon concentration is 5E+16 atoms/cm³ or more in at least 1 um region of the front and the back surface, thus more reliably preventing dislocation propagation and thus plastic deformation in the silicon single-crystal substrate.

Furthermore, it is preferable to have an Al layer between the front surface of the silicon single crystal substrate and the nitride semiconductor thin film.

With the Al layer on the growth surface side of the silicon single crystal substrate, adhesiveness can be improved between the silicon single crystal substrate and an epitaxial layer.

In this case, the Al layer preferably has a thickness of 1 to 5 nm.

When the thickness is 5 nm or less, unevenness of the Al layer is reduced, and the surface roughness of the nitride semiconductor layer grown thereon is also reduced. In addition, when the thickness is 1 nm or more, the front surface of the silicon single crystal substrate is sufficiently coated, thereby further improving adhesiveness of the nitride semiconductor thin film.

In addition, the present invention provides:
a method for producing a nitride semiconductor substrate including a silicon single crystal substrate having a front surface and a back surface; and a nitride semiconductor thin film formed on the front surface, the method comprising the steps of:
(1) providing a silicon single crystal substrate having a front surface and a back surface;
(2) implanting carbon into at least the front surface and the back surface of the silicon single crystal substrate by an RTA method to form a carbon diffusion layer with a carbon concentration of 5E+16 atoms/cm³ or more; and
(3) growing a nitride semiconductor thin film containing gallium nitride by vapor deposition on the front surface of the silicon single crystal substrate into which the carbon diffusion layer is formed.

According to such a production method to implant high concentration carbon into the silicon single crystal substrate by the RTA method, it is possible to produce a nitride semiconductor wafer relatively easily and reliably, in which plastic deformation and a warp are suppressed, without inhibiting single crystallization as in a carbon-doping method during silicon single crystal growth.

Moreover, in the Step (1), it is preferred that the silicon single crystal substrate to be provided has a resistivity of 100 Qcm or more and an oxygen concentration of 7E+17 atoms/cm³ or less.

In the present invention, even when a silicon single crystal substrate having a high resistivity, a low oxygen concentration, and low mechanical strength is used, it is possible to produce the nitride semiconductor wafer in which plastic deformation and a warp are suppressed.

In addition, in the Step (2), it is preferred that the carbon diffusion layer has a thickness of 1 um or more.

With such a thickness, propagation of dislocation in the silicon single crystal substrate can be prevented more reliably, thus, the nitride semiconductor wafer with a suppressed warp can be produced easily.

Moreover, between the Step (2) and the Step (3), it is preferred that (2') forms an Al layer using trimethylaluminum (TMA) at a temperature of 900°C or less on the front surface of the silicon single-crystal substrate into which the carbon diffusion layer is formed.

In this way, the Al layer can be easily formed, and thus the nitride semiconductor substrate having improved adhesiveness of the epitaxial layer can be produced.

In this case, in the Step (2'), it is preferred that the Al layer has a thickness of 1 to 5 nm.

When the thickness is 5 nm or less, the unevenness on the Al layer is reduced, and the surface roughness of the nitride semiconductor layer grown thereon is also reduced. In addition, when the thickness is 1 nm or more, the front surface of the silicon single crystal substrate is sufficiently coated, thereby further improving adhesiveness of the nitride semiconductor thin film.

### ADVANTAGEOUS EFFECTS OF INVENTION

As described above, the present invention can provide a nitride semiconductor substrate that can suppress warp failure caused by plastic deformation during epitaxial growth and device production processes when the nitride semiconductor substrate is produced using a silicon single crystal substrate having a high resistance and low oxygen, and a method for producing the nitride semiconductor substrate. Moreover, with an Al layer formed as an intermediate layer on the epitaxial growth surface of the substrate, the adhesiveness with the nitride semiconductor thin film can be further improved.

### BRIEF DESCRIPTION OF DRAWINGS

FIG. 1 is a schematic view illustrating an example of a nitride semiconductor substrate according to the present invention.
FIG. 2 is a schematic view illustrating an example of a silicon single crystal substrate used for the present invention.
FIG. 3 is a schematic view illustrating an example of a nitride semiconductor thin film used for the present invention.
FIG. 4 is a graph showing changes in the curvature of the substrate during the growth of a nitride semiconductor thin film in Example 1 and Comparative Example 1.

### DESCRIPTION OF EMBODIMENTS

As described above, it has been desired to develop a nitride semiconductor substrate that can suppress warp failure caused by plastic deformation during epitaxial growth and device processes when the nitride semiconductor substrate is produced using a silicon single crystal substrate, and a method for producing the nitride semiconductor substrate.

To solve the above problem, the present inventors have earnestly studied and found that the silicon single crystal substrate with carbon implanted into the surface by an RTA method can suppress plastic deformation during the growth of a nitride semiconductor thin film. This finding has led to the completion of the present invention.

That is, the present invention is a nitride semiconductor substrate comprising:
a silicon single crystal substrate having a front surface and a back surface; and a nitride semiconductor thin film formed on the front surface, wherein
the silicon single crystal substrate has a carbon diffusion layer that has been implanted with carbon and has a carbon concentration higher than a bulk portion of the silicon single crystal substrate in at least the front surface and the back surface, and
the carbon concentration in the carbon diffusion layer is 5E+16 atoms/cm³ or more.

Moreover, the present invention is a method for producing a nitride semiconductor substrate including a silicon single crystal substrate having a front surface and a back surface; and a nitride semiconductor thin film formed on the front surface, the method comprising the steps of:
(1) providing a silicon single crystal substrate having a front surface and a back surface;
(2) implanting carbon into at least the front surface and the back surface of the silicon single crystal substrate by an RTA method to form a carbon diffusion layer with a carbon concentration of 5E+16 atoms/cm³ or more; and
(3) growing a nitride semiconductor thin film containing gallium nitride by vapor deposition on the front surface of the silicon single crystal substrate into which the carbon diffusion layer is formed.

Hereinafter, the present invention will be described in detail. However, the present invention is not limited thereto.

### <Nitride Semiconductor Substrate>

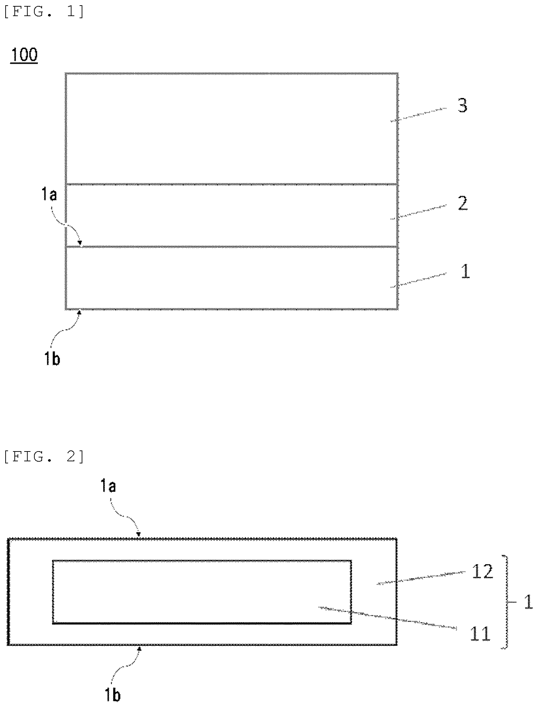

As shown in FIG. 1, the inventive nitride semiconductor substrate 100 has a silicon single crystal substrate 1 having a front surface 1a and a back surface 1b; and a nitride semiconductor thin film 3 formed on the front surface 1a. Moreover, an Al layer 2 may be present as an intermediate layer between the front surface 1a of the silicon single crystal substrate 1 and the nitride semiconductor thin film 3. Besides, as shown in FIG. 2, the silicon single crystal substrate 1 in the present invention has a carbon diffusion layer 12 that has been implanted with carbon and has a carbon concentration higher than a bulk portion 11 of the silicon single crystal substrate 1 in at least the front surface 1a and the back surface 1b, and the carbon concentration in the carbon diffusion layer 12 is 5E+16 atoms/cm³ or more.

### Silicon Single Crystal Substrate

In order to decrease parasitic capacity, the silicon single crystal substrate preferably has a resistivity of 100 Qcm or more and an oxygen concentration of 7E+17 atoms/cm³ or less. The silicon single crystal substrate before carbon implantation is desirably a low oxygen and high resistivity silicon single crystal substrate having low thermal donor effect to reduce leakage current through the substrate, especially a substrate produced by an FZ method; however, a silicon single crystal substrate produced by a CZ method is also acceptable as long as the substrate has high resistivity and low oxygen. In addition, the upper limit of the resistivity is not particularly limited but can be, for example, 10000 Qcm or less. The lower limit of the oxygen concentration is not particularly limited, but can be, for example, 0 atoms/cm³ or more.

Moreover, used is the substrate in which a carbon diffusion layer having a carbon concentration of 5E+16 atoms/cm³ or more is incorporated into the front surface and the back surface. The carbon diffusion layer may be formed into the side surface of the substrate. When the carbon concentration is less than 5E+16 atoms/cm³, it is impossible to obtain an effect to suppress plastic deformation during epitaxial growth. The upper limit of the carbon concentration in the carbon diffusion layer is not particularly limited but can be, for example, 2E+17 atoms/cm³ or less.

The thickness of the carbon diffusion layer is not particularly limited but can be, for example, 1 um or more. The upper limit of the thickness is not particularly limited, but can be, for example, 20 um or less, preferably 10 um or less, more preferably 5 um or less.

The method for producing the carbon diffusion layer is not particularly limited but it is preferable to produce the layer by heat treatment in an atmosphere containing hydrocarbons using an RTA method.

A trap-rich layer for reducing the lifetime of carriers may be formed on the surface of the silicon single crystal substrate. The trap-rich layer can be formed by ion implantation or irradiation with ionizing radiation such as electron beam, X-ray, and γ-ray, but is not limited to these.

### Al layer

In the inventive nitride semiconductor substrate, an Al layer may be provided as an intermediate layer. The Al layer serves as a buffer layer to be inserted for improving crystallinity or controlling stress of the nitride semiconductor thin film (device layer). By forming the Al layer mainly made of Al on the surface (top surface) of the silicon single crystal substrate implanted with carbon by the RTA method, the crystallinity and crystal morphology of the nitride semiconductor thin film (epitaxial layer) are improved and delamination of the epitaxial layer is more reliably prevented by improving adhesiveness.

It is preferred that the Al layer has a thickness of 1 to 5 nm. When the thickness is 5 nm or less, unevenness of the Al layer is reduced and thus surface roughness of the nitride semiconductor layer grown thereon is also reduced. Moreover, when the thickness is 1 nm or more, the surface of the silicon single crystal substrate is sufficiently coated, thereby improving the adhesiveness of the nitride semiconductor thin film.

### Nitride Semiconductor Thin Film

The nitride semiconductor thin film is produced by vapor phase growth, such as a thermal CVD method, an MOVPE method, an MBE method, a vacuum deposition method, and a sputtering method, on the silicon single crystal substrate or the Al layer. The nitride semiconductor thin film can be made of nitrides such as GaN, AlN, InN, AlGaN, InGaN, AlInN, and AlScN, and group III-V semiconductors. The film thickness is not particularly limited but can be, for example, 1 to 10 um and designed according to a device.

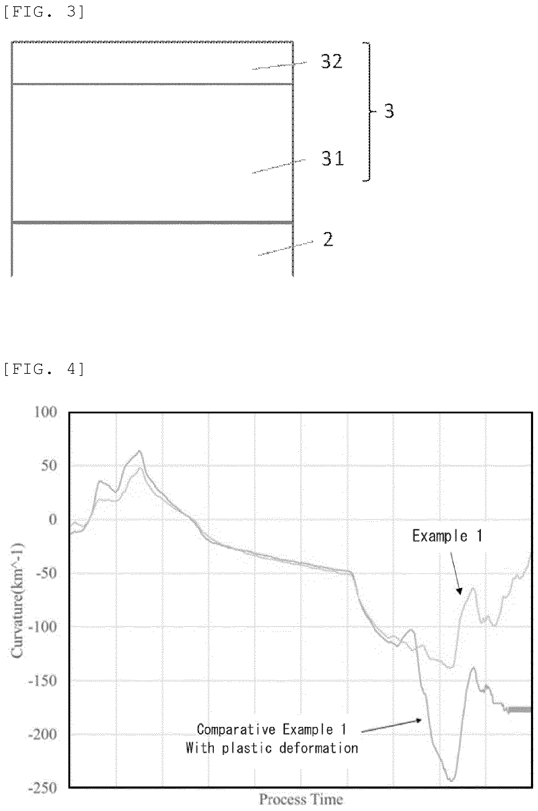

For example, as shown in FIG. 3, in a high mobility transistor (HEMT) structure, the nitride semiconductor thin film (device layer) 3 is configured from gallium nitride (GaN) 31 and an electron supply layer 32 made of AlGaN formed thereon. With regard to the nitride semiconductor thin film, a crystal having few crystal defects and few impurities such as carbon or oxygen is desired for improving device characteristics, and the crystal is preferably produced at 900°C to 1350°C using the MOVPE method.

Gallium nitride and Si (111) single crystal have a difference in lattice constant of 17 % and a difference in thermal expansion coefficient of 116%, and thus the thin film and substrate are stressed during growth at a high temperature. Heated at 1000°C or higher during the growth, the wafer is applied with stress to show ductility without brittle fracture. Thus dislocation is generated to lead plastic deformation. However, in the present invention, by implanting carbon into the front and the back surfaces, propagation of dislocation in the silicon single crystal substrate is prevented, thereby preventing the plastic deformation. By preventing the plastic deformation, it is possible to decrease warp abnormality and improve the yield. Moreover, as the substrate can withstand the stress, the film thickness of the epitaxial layer can be thickened, thus, the degree of freedom in device design is improved.

### <Method for Producing Nitride Semiconductor Substrate>

The inventive nitride semiconductor substrate can be produced according to the inventive method for producing the nitride semiconductor substrate, which includes Steps (1) to (3) described below and, when necessary, Step (2') described below.

### Step (1)

Step (1) is a step of providing a silicon single crystal substrate having a front surface and a back surface. The silicon single crystal substrate provided in this step is not particularly limited but can be, for example, the above-described silicon single crystal substrate having a small parasitic capacity, a resistivity of 100 Qcm or more, and an oxygen concentration of 7E+17 atoms/cm³ or less. The silicon single crystal may be produced by either an FZ method or a CZ method, but the FZ method is more preferable.

### Step (2)

Step (2) is a step of implanting carbon into at least the front surface and the back surface of the silicon single crystal substrate by an RTA method to form a carbon diffusion layer with a carbon concentration of 5E+16 atoms/cm³ or more.

The condition for the RTA treatment in this step is not particularly limited as long as it is possible to implant carbon into the front surface and the back surface of the silicon single crystal substrate. The atmosphere in the RTA treatment can be, for example, a mixed atmosphere containing hydrocarbon gas and Ar. Moreover, the temperature and time for the RTA treatment can be, for example, at a temperature of 1100°C or more and the melting point of silicon or less for 10 seconds or more and 150 seconds or less.

### Step (2')

Between the Step (2) and the Step (3), it is possible to perform (2') forming an Al layer using trimethylaluminum (TMA) at a temperature of 900°C or less on the front surface of the silicon single-crystal substrate into which the carbon diffusion layer is formed. The Al layer can have a thickness of 1 to 5 nm, for example. In addition, the lower limit of the temperature, when the Al layer is formed, is not particularly limited but can be, for example, 450°C or more.

In this step, to form the Al layer on the front surface of the silicon single crystal substrate, trimethylaluminum is introduced as the Al source material under a condition in which the inside of the furnace is at a high temperature, and then the flow rate and time are adjusted to achieve the desired film thickness. Although the carrier gas is not particularly limited, hydrogen, for example, can be used.

### Step (3)

The Step (3) is a step of growing a nitride semiconductor thin film containing gallium nitride by vapor phase growth on the front surface of the silicon single crystal substrate into which the carbon diffusion layer is formed.

In this step, a device layer made of a nitride semiconductor thin film containing gallium nitride is produced by vapor phase growth, such as a thermal CVD method, an MOVPE method, an MBE method, a vacuum deposition method, or a sputtering method. Examples of the thin film to be used include nitrides and group III-V semiconductors such as GaN, AlN, InN, AlGaN, InGaN, AlInN, and AlScN. The film thickness is, for example, 1 to 10 um and can be designed according to a device.

During epitaxial growth, TMAl can be used as an Al source, TMGa as a Ga source, and NH₃ as an N source. In addition, N₂ and H₂, or either of them, can be used as the carrier gas, and the process temperature can be about 900 to 1350°C.

In this step, stress is applied to the silicon single crystal substrate; however, as the carbon diffusion layer is formed into the front surface of the silicon single crystal substrate as described above, propagation of dislocation in the silicon single crystal substrate is prevented, and thus the plastic deformation thereof can be prevented. Consequently, the nitride semiconductor substrate with a small warp can be produced in the present invention.

### EXAMPLE

Hereinafter, the present invention will be specifically described with reference to Examples and Comparative Examples. However, the present invention is not limited thereto.

### (Example 1)

A silicon single crystal substrate was provided by an FZ method with a resistivity of 100 Qcm or more and no oxygen added.

Carbon was implanted into the front surface and the back surface of the silicon single crystal substrate described above by heat treatment using an RTA method. The condition for heat treatment was to perform heat treatment at 1250°C for 10 sec in an atmosphere of CH₄ and Ar and then a carbon diffusion layer of 1 um having a carbon concentration of 5E+16 atoms/cm³ was formed into the surface layer of the silicon single crystal substrate.

A nitride semiconductor thin film was epitaxially grown by an MOVPE method to the silicon single crystal substrate, in which the carbon concentration in the surface layer was increased. The growth temperature was 1000 to 1200°C, and an epitaxial layer of a nitride semiconductor having a total film thickness of 2.8 um was grown. The more specific production method is shown below.

### [1] Introduction to Reaction Furnace

The silicon single crystal substrate was introduced into the reaction furnace of an MOVPE apparatus, and then the inside of the furnace was filled with nitrogen gas to exhaust the gas inside of the furnace.

### [2] Cleaning the Front Surface of the Substrate in the Furnace

The substrate was heated in the reaction furnace to clean the front surface of the substrate. The temperature for cleaning was 1050°C, the pressure in the furnace was 50 mbar, and the cleaning was performed for 10 minutes while a gas mixture of hydrogen, nitrogen, ammonia, and the like was supplied to the furnace.

### [3] Forming Al Layer

Next, to form an Al layer on the substrate, while the furnace was at a high temperature condition, trimethylaluminum was introduced as a raw material for Al, and the flow rate and time were adjusted so as to form a film thickness of 2 nm. Hydrogen was used as the carrier gas.

### [4] Growing Epitaxial Layer

Then, the nitride semiconductor thin film was epitaxially grown at a pressure in the furnace of 50 mbar and a substrate temperature of 1120°C. Trimethylaluminum (TMAl) was used as an Al source, trimethylgallium (TMGa) as a Ga source, and ammonia (NH₃) as an N source. First, AlN was grown with a flow rate of 0.24 L/min (240 sccm) for TMAl and 2.0 L/min (2000 sccm) for NH₃ under a standard condition. Hydrogen was used as the carrier gas for TMAl, TMGa, and NH₃. Similarly, the flow rate of TMAl, TMGa, and NH₃, growth temperature, and growth time were determined, and then a buffer layer and a gallium nitride layer were grown.

By producing a GaN epitaxial substrate in this way, a high-quality GaN epitaxial substrate was successfully obtained, using the silicon single crystal substrate having a high resistivity and low oxygen, thus not prone to generate thermal donor. Changes in Curvature (km⁻¹) during the epitaxial growth are shown in FIG. 4. It has been found that, with the carbon diffusion layer having a carbon concentration of 5E+16 atoms/cm³ or more provided in the silicon single crystal substrate, the substrate is not plastically deformed during the growth. In addition, the warp amount after the growth was 41 µm, which was about one-fifth compared with Comparative Example 1 described later.

### (Example 2)

In heat treatment for the silicon single crystal substrate by an RTA method, a nitride semiconductor substrate was produced in the same way as in Example 1, except that the heat treatment condition was 1250°C for 30 sec in an atmosphere of CH₄ and Ar. In this case, the carbon concentration in the carbon diffusion layer was 8E+16 atoms/cm³. The warp amount after growth was 39 µm, which means that plastic deformation was successfully suppressed.

### (Example 3)

In heat treatment for the silicon single crystal substrate by an RTA method, a nitride semiconductor substrate was produced in the same way as in Example 1, except that the heat treatment condition was 1300°C for 10 sec in an atmosphere of CH₄ and Ar. In this case, the carbon concentration in the carbon diffusion layer was 2E+17 atoms /cm³. The warp amount after growth was 35 µm, which means that plastic deformation was successfully suppressed.

### (Comparative Example 1)

A GaN epitaxial layer was grown in the same condition as in Example 1, except that the step to implant carbon into the surface layer by an RTA method in Example 1 was not performed. As can be seen from FIG. 4, the substrate was plastically deformed during the growth. The warp amount after growth was 213 um.

### (Comparative Example 2)

In heat treatment for the silicon single crystal substrate by an RTA method, a nitride semiconductor substrate was produced in the same way as in Example 1, except that the heat treatment condition was 1225°C for 10 sec in an atmosphere of CH₄ and Ar. In this case, the carbon concentration in the carbon diffusion layer was 2E+16 atoms/cm³. The warp amount after growth was 192 um and it has been confirmed that when the carbon concentration in the carbon diffusion layer is low, plastic deformation is unable to be suppressed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate comprising:
a silicon single crystal substrate having a front surface and a back surface; and a nitride semiconductor thin film formed on the front surface, wherein
the silicon single crystal substrate has a carbon diffusion layer that has been implanted with carbon and has a carbon concentration higher than a bulk portion of the silicon single crystal substrate in at least the front surface and the back surface, and
the carbon concentration in the carbon diffusion layer is 5E+16 atoms/cm³ or more.

2. The nitride semiconductor substrate according to claim 1, wherein
the silicon single crystal substrate has a resistivity of 100 Qcm or more and an oxygen concentration of 7E+17 atoms/cm³ or less.

3. The nitride semiconductor substrate according to claim 1 or 2, wherein
the carbon diffusion layer has a thickness of 1 um or more.

4. The nitride semiconductor substrate according to any one of claims 1 to 3, having an Al layer between the front surface of the silicon single crystal substrate and the nitride semiconductor thin film.

5. The nitride semiconductor substrate according to claim 4, wherein
the Al layer has a thickness of 1 to 5 nm.

6. A method for producing a nitride semiconductor substrate including a silicon single crystal substrate having a front surface and a back surface; and a nitride semiconductor thin film formed on the front surface, the method comprising the steps of:
(1) providing a silicon single crystal substrate having a front surface and a back surface;
(2) implanting carbon into at least the front surface and the back surface of the silicon single crystal substrate by an RTA method to form a carbon diffusion layer with a carbon concentration of 5E+16 atoms/cm³ or more; and
(3) growing a nitride semiconductor thin film containing gallium nitride by vapor deposition on the front surface of the silicon single crystal substrate into which the carbon diffusion layer is formed.

7. The method for producing a nitride semiconductor substrate according to claim 6, wherein
in the Step (1), the silicon single crystal substrate to be provided has a resistivity of 100 Qcm or more and an oxygen concentration of 7E+17 atoms/cm³ or less.

8. The method for producing a nitride semiconductor substrate according to claim 6 or 7, wherein
in the Step (2), the carbon diffusion layer has a thickness of 1 um or more.

9. The method for producing a nitride semiconductor substrate according to any one of claims 6 to 8, comprising,
between the Step (2) and the Step (3), (2') forming an Al layer using trimethylaluminum (TMA) at a temperature of 900°C or less on the front surface of the silicon single-crystal substrate into which the carbon diffusion layer is formed.

10. The method for producing a nitride semiconductor substrate according to claim 9, wherein
in the Step (2'), the Al layer has a thickness of 1 to 5 nm.
